# EUROPEAN PATENT APPLICATION

(11) **EP 1 414 233 A1**
(43) Date of publication of application: **28.04.2004**
(21) Application number: 03010381.6
(22) Date of filing: 08.05.2003
(51) Int. Cl.: H04N 5/00, G06F 12/14

(54) **System and method for configuring device features via programmable memory**

(30) Priority: 08.05.2002 US 141197; 08.05.2002 US 141599; 08.05.2002 US 141549
(71) Applicant: Broadcom Corporation, Irvine, California 92618-7013 (US)
(72) Inventor: Carr, Jeffrey Douglas, Poway, California 92064 (US)
(74) Representative: Jehle, Volker Armin, Dipl.-Ing.

(57) **Abstract**

Systems and methods that may configure features or functions of a device, such as a set top box, for example, using a chip are provided. The chip may include a processor and a memory array. The memory array may include a non-volatile memory and may be in communications with the processor. The non-volatile memory may include a set of mode control bits, each mode control bit being one-time programmable. The device features may be securely programmed via the set of mode control bits of the non-volatile memory that may be programmed during a programming cycle and may not be modified further after the completion of the programming cycle.

## Description

### FIELD OF THE INVENTION

The present invention relates generally to systems and methods for configuring a device and, more specifically, to systems and methods for configuring device features via a programmable memory.

### BACKGROUND OF THE INVENTION

Devices are generally manufactured with particular features and functions that meet the particular requirements of customers. However, this can be a costly undertaking, especially where a wide variety of features and functions are available and customer preferences are equally diverse. To make a new line of devices that have the features or perform the functions according to each customer's specification would require a process involving additional design time and manufacture set up, and such a process would lack many of the efficiencies that result from economies of scale. Under these circumstances, such a customized solution may be impractical.

In addition, even if such a customized solution is implemented, it still lacks the flexibility to permit modification (e.g., enabling or disabling) of particular features or functions as customer needs change. Thus, a customer who would like to enable or to disable a particular feature or function would have to purchase another new line of devices that are designed and manufactured to incorporate the modifications.

On the other hand, a device with all of the available features and functions enabled might not necessarily meet the requirements of most customers. For example, some customers might not have the advanced systems capable of handling devices enabled with the highest levels of security or encryption. Accordingly, such a solution still would lack flexibility. Furthermore, a device with all of the available features and functions enabled may be more costly than most customers would be willing to pay.

Further limitations and disadvantages of conventional and traditional approaches will become apparent to one of skill in the art, through comparison of such systems with the present invention as set forth in the remainder of the present application with reference to the drawings.

What is needed, therefore, is a device that, for example, permits a customer to conveniently enable or disable allowed features and functions, but that also prohibits a customer from enabling non-allowed features and functions, in a cost efficient and secure manner.

### SUMMARY OF THE INVENTION

Aspects of the present invention may be found in systems and methods that may configure features (functions) of a device using a chip. In one embodiment, the present invention may provide a chip that includes a processor and a memory array. The memory array includes a non-volatile memory and is in communications with the processor. The non-volatile memory includes a set of mode control bits, each mode control bit being one-time programmable. The device features are securely programmed via the set of mode control bits.

In another embodiment, the present invention may provide a system that configures functions of a device using an on-chip, one-time programmable non-volatile memory. The non-volatile memory includes a set of mode control bits whose bit values correspond to a particular configuration of the device functions. The set of mode control bits may be one-time programmable during a programming cycle.

In yet another embodiment, the present invention may provide a method that configures functions of a device using a non-volatile memory. The method may include the steps of beginning a programming cycle; programming mode control bits of the non-volatile memory; terminating the programming cycle; and determining programmed configurations of the device by reading the programmed mode control bits of the non-volatile memory.

In a further embodiment of the above-described method, the method may include the additional step of not allowing further programming of the mode control bits after terminating the programming cycle.

These and other features and advantages of the present invention may be appreciated from a review of the following detailed description of the present invention, along with the accompanying figures in which like reference numerals refer to like parts throughout.

### BRIEF DESCRIPTION OF THE DRAWINGS

FIG. 1 shows an example of a device including a chip according to the present invention.
FIG. 2 shows a table illustrating an example of a memory allocation within a non-volatile memory according to the present invention.
FIG. 3 is a flowchart illustrating an example of a method for programming a non-volatile memory according to the present invention.

### DETAILED DESCRIPTION OF THE INVENTION

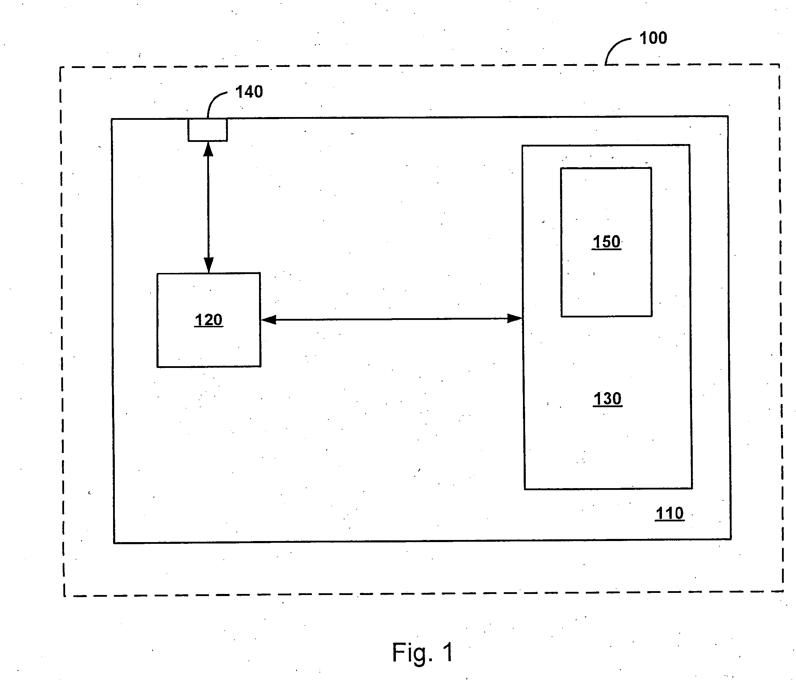

FIG. 1 shows an example of a device 100 including a chip 110 according to the present invention. Although the chip 110 is illustrated as part of the device 100, it may be external to the device 100 and merely coupled to the device 100. The chip 110 may include a processor 120, a memory array 130 and a chip interface 140. The memory array 130 may include a non-volatile memory 150 such as, for example, a one-time programmable non-volatile memory. The non-volatile memory 150 may include, for example, banks of mode control bits. The processor 120 is coupled to the memory array 130 and the chip interface 140 via buses or other conventional communication means. The device 100 communicates with the chip 110 via, for example, the chip interface 140. In one embodiment, the device 100 is a set top box, for example. Of course, other types of devices are also contemplated by the present invention.

In operation, the non-volatile memory 150 of the memory array 130 can be programmed during a programming cycle by the processor 120 or by data received by the processor 120 via the chip interface 140. During the programming cycle, the banks of mode control bits are programmed which correspond to configurations of features or functions of the device 100 that are desired. Each bank of mode control bits is protected against future writing by a lockout mechanism which, when enabled, prohibits the bits from changing states. A bank can be locked out using protection built into the programming cycle. For example, when the programming cycle is complete, future writing of particular mode control bits can be prohibited.

In some embodiments, the present invention may provide some customers with access to special internal device capabilities (e.g., cases in which the customer has paid the appropriate licensing fee or premium fee), but allow other customers to disable or to be unable to access such capabilities. For example, if a customer desires a special algorithm or a special cryptographic configuration enabled within the device 100, the appropriate mode control bits can be programmed during the programming cycle to enable the desired configurations, features or functions of the device 100. If a customer wants to disable a feature or, perhaps, if the customer is not permitted to access such feature, the non-volatile memory 150 may be so programmed or the device 100 may resort to default values stored in the non-volatile memory 150. Alternatively, the device 100 may not use the non-volatile memory 150 at all during set up or operation.

Programming can be initiated, for example, locally at the manufacturing site or at a point of service or can be initiated remotely at a central processing center that can send the appropriate programming data via cables or wirelessly, ultimately reaching the chip interface 140. Such programming data and the transmission thereof may benefit from appropriate security measures (e.g., encryption schemes) and unique identification (e.g., a unique identifier of the device 100 or the chip 110).

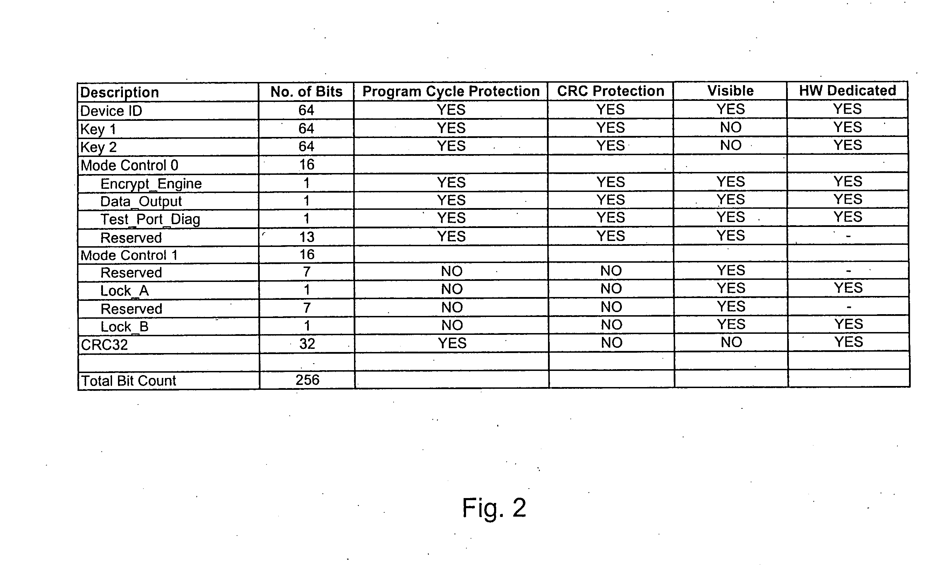

FIG. 2 shows a table illustrating an example of the memory allocation within the non-volatile memory 150 according to the present invention. The first two columns of the table provide field descriptions and respective bit allocations. The next four columns of the table provide memory bit attributes. Program Cycle Protection indicates whether the memory bits can only be written during a programming cycle and whether the memory bits are locked-out or protected from programming at the completion of the programming cycle. Cyclic Redundancy Check (CRC) Protection indicates whether the memory bits are protected by CRC and whether the memory bits are included in a CRC calculation. For example, CRC32 is a 32-bit CRC calculated on fields starting with the Device ID and continuing through the Mode Control 0 bank of mode control bits. Visible indicates whether the memory bit is readable, for example, by the processor 120, the device 100 or outside of the device 100. Hardware Dedicated indicates whether the bit states are used as part of internal hardware logic or are used only as programmable information bits.

The fields within the non-volatile memory can be generally described as memory data bits, mode control bits and memory management bits. The memory data bits may include, for example, the Device ID, Key 1 and Key 2. Device ID is 64-bits that are visible (i.e., that can be read out by the processor 120) and can provide a unique identifier for the device 100. Key 1 and Key 2 are each 64-bits, not visible outside the device 100 and are used inside the chip 110 as input to cryptographic functions (e.g., data encryption standard (DES) techniques). Additional information relating to cryptography, encryption and other matters can be found in United States Patent Application Serial No. / entitled "System and Method for the Concealment of Device Input Parameters" to Jeffrey D. Carr which was filed on July 6, 2001, and which is hereby incorporated herein by reference in its entirety.

The mode control bits may include, for example, Mode Control 0 and Mode Control 1. In this example, each bit in the mode control bits may represent a function or feature configuration for the device 100. However, a plurality of bits in the mode control bits may represent one or more function or feature configurations for the device 100. Mode control bits can also be used to control onboard logic in other sections of the device 100.

For example, the Encrypt_Engine mode control bit may have a default value which configures the device 100 for a particular level of encryption or security (e.g., selectable between no encryption, DES or 3DES). When the Encrypt_Engine mode control bit is programmed (e.g., from a binary 0 to a binary 1), the device 100 may be forced into the highest security mode (e.g., 3DES).

In another example, the Data_Output mode control bit may have a default value which enables a data output interface of the device 100. When the Data_Output mode control bit is programmed, the device 100 may disable the data output interface. Similarly, the Test_Port_Diag mode control bit may enable or disable access to test ports of the device 100 depending upon whether the Test_Port_Diag mode control bit stored the default or programmed value.

Lock_A and Lock_B bits may, for example, lockout programming of the respective seven reserved bits of Mode Control 1. The reserved bits may be provide for the selection of features or functions outside of the programming cycle. Accordingly, some of the mode control bits can be locked out after the programming cycle, while other mode control bits can be programmed (e.g., one-time programmed) and locked out by programming the appropriate lockout bit.

Other features and functions of the device 100 that may be configured via the mode control bits include, for example, display, sound or authentication configurations. The above-described features and functions of the device 100 are not intended to be exhaustive and maybe dependent upon the choice of the device 100. Accordingly, one of ordinary skill in the art can determine additional features and functions of the device 100 (e.g., a set top box) that can be configured by the control mode bits without undue experimentation.

The memory management bits may include, for example, CRC32 and Programming Bits. The CRC32 is a 32-bit result from running the CRC32 algorithm over at least a portion of the non-volatile memory bits such as, for example, the bits which are part of Device ID, Key 1, Key 2 and Mode Control 0. Accordingly, data contents can be validated. The other memory management bits include the Programming Bits, which are, for example, two bits used to indicate the programming status of the device 100.

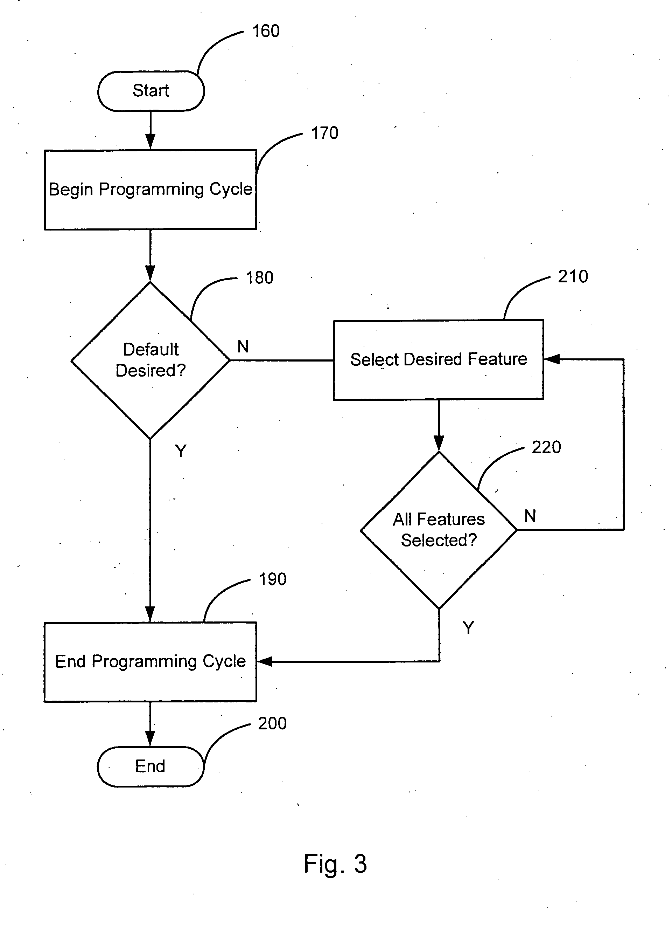

FIG. 3 is a flowchart illustrating an example of a method for programming the non-volatile memory 150 according to the present invention. The process begins with steps 160 and 170 which include the start of the process and the beginning of the programming cycle, respectively. The beginning of the programming cycle may include the programming of the first of the Programming Bits. In query 180, it is determined whether the default values already stored in the non-volatile memory 150 are desired. The default values may or may not be all binary zeroes. If the default values of the non-volatile memory 150 are desired, then the process jumps to step 190. In step 190, the programming cycle ends. The ending of the programming cycle may include the programming of the second of the Programming Bits. With the programming of the second of the Programming Bits, the bits in the non-volatile memory 150 with Program Cycle Protection as set forth, for example, in FIG. 2 can not be further modified. The process ends in step 200.

In query 180, if it is determined that the default values of the non-volatile memory 150 are not desired, then the process jumps to step 210. In step 210, the device 100 is configured for a particular feature or a particular function by programming the corresponding bit or bits in the non-volatile memory 150. For example, the Encrypt_Engine mode control bit can be programmed to force the device 100 into the highest level of encryption security. After selecting a desired feature, the process moves to query 220 in which it is determined whether all of the features desired have been selected. If not, then the configuring of the device 100 continues back at step 210. If all of the desired features have been selected then the process jumps to steps 190 and 200 and the ending of the programming cycle and the ending of the process, respectively, as described above.

The use of the first Programming Bit (FPB) and the second Programming Bit (SPB) add a hardware layer of protection and security for the programming cycle. As indicated, after a successful programming cycle, both the FPB and the SPB have programmed values (e.g., both will have binary ones stored in the respective bits, the "11" state). Accordingly, the non-volatile memory 150 becomes operational and the device 100 can be configured according to the values programmed in the non-volatile memory 150.

Under other conditions in which both Programming Bits are not both programmed, the non-volatile memory 150 is not operational. In the case in which the FPB is programmed and the SPB is not programmed (e.g., the "10" state), for example, during an intermediate step of the programming cycle, read access to the non-volatile memory is disabled. The "10" state may also occur if a reset condition occurred during a programming cycle. Under such a condition, the non-volatile memory 150 will not allow any further programming and will be rendered invalid (i.e., cannot be accessed). The case in which the FPB is not programmed and the SPB is programmed (e.g., the "01" state), is an illegal state and should not occur. If either the "10" state or the "01" state does occur as the device 100 comes up from reset or during normal operation, it may be assumed that the non-volatile memory 150 was not programmed correctly or that the non-volatile memory 150 was improperly tampered with. In either case, access to the non-volatile memory 150 is disabled. The mode controls may also be enabled to their most secure state (e.g., programmed to binary ones).

Thus, it is seen that systems and methods for configuring device features via programmable memory are provided. One skilled in the art will appreciate that the present invention can be practiced by other than the preferred embodiments which are presented in this description for purposes of illustration and not of limitation, and that the present invention is limited only by the claims that follow. It is noted that equivalents for the particular embodiments discussed in this description may practice the present invention as well.

## Claims

1. A system for configuring features of a device using a chip, the chip comprising:
a processor; and
a memory array including a non-volatile memory, the memory array being in communications with the processor, the non-volatile memory including a set of mode control bits, each mode control bit being one-time programmable,
wherein the device features are securely programmed via the set of mode control bits.

2. The system according to claim 1,
wherein the non-volatile memory includes a first programming control bit that is one-time programmable, and
wherein, after the first programming control bit is programmed, each mode control bit can be programmed.

3. The system according to claim 1, wherein each mode control bit corresponds to the configuring of a respective feature of the device.

4. The system according to claim 1, wherein at least one of the mode control bits corresponds to enabling and to disabling test port functions of the device.

5. The system according to claim 1, wherein at least one of the mode control bits corresponds to enabling and to disabling data port functions of the device.

6. The system according to claim 1, wherein at least one of the mode control bits corresponds to an encryption engine configuration.

7. The system according to claim 1, wherein at least one of the mode control bits corresponds to a display configuration.

8. The system according to claim 1, wherein at least one of the mode control bits corresponds to a sound configuration.

9. The system according to claim 1, wherein the mode control bits have default values.

10. The system according to claim 2,
wherein the non-volatile memory includes a second programming control bit that is one-time programmable, and
wherein, after the second programming control bit is programmed subsequent to the programming of the first programming control bit, the set of mode control bits can no longer be programmed.

11. The system according to claim 10, wherein after the first programming control bit and the second programming control bit have been programmed, the non-volatile memory is readable by the device.

12. The system according to claim 10, wherein the first programming control bit and the second programming control bit are always readable by the device.

13. The system according to claim 1, wherein the device is operational even if the non-volatile memory has not been programmed.

14. The system according to claim 1, wherein the non-volatile memory includes error correction bits that store values derive from an error correction algorithm over at least some bits of the non-volatile memory.

15. The system according to claim 1, wherein the non-volatile memory includes bits that store at least one encryption key.

16. The system according to claim 1, wherein the non-volatile memory includes bits that store a device identification that can be read out of the chip.

17. The system according to claim 1, wherein the device is a set top box.

18. A system for configuring functions of a device using an on-chip one-time programmable non-volatile memory, the non-volatile memory comprising:
a set of mode control bits whose bit values correspond to a particular configuration of the device functions, the set of mode control bits being one-time programmable during a programming cycle.

19. The system according to claim 18, wherein, after the programming cycle, the set of mode control bits cannot be further programmed.

20. A method for configuring functions of a device using a non-volatile memory, comprising the steps of:
beginning a programming cycle;
programming mode control bits of the non-volatile memory;
terminating the programming cycle; and
determining programmed configurations of the device by reading the programmed mode control bits of the non-volatile memory.

21. The method according to claim 20, further comprising the step of:
not allowing further programming of the mode control bits after terminating the programming cycle.

22. The method according to claim 20, wherein the step of beginning the programming cycle includes the step of programming a first programming control bit.

23. The method according to claim 22, wherein the step of terminating the programming cycle includes the step of programming a second programming control bit.

24. The method according to claim 20, wherein the step of determining occurs after the steps of beginning and terminating.

25. The method according to claim 20, wherein the mode control bits are one-time programmable mode control bits.

26. The method according to claim 20, wherein the non-volatile memory is an on-chip, one-time-programmable non-volatile memory.

27. The method according to claim 20, wherein the device is a set top box.
